**Europäisches Patentamt**

(19) **European Patent Office**

**Office européen des brevets**

(11) Veröffentlichungsnummer: **0 062 102**
**B1**

(12) # EUROPÄISCHE PATENTSCHRIFT

(45) Veröffentlichungstag der Patentschrift:
**20.04.88**

(51) Int. Cl.⁴: **H 01 L 29/08,** H 01 L 29/743

(21) Anmeldenummer: **81108717.0**

(22) Anmeldetag: **22.10.81**

(54) Thyristor mit anschaltbarer innerer Stromverstärkung und Verfahren zu seinem Betrieb.

(30) Priorität: **31.03.81 DE 3112940**

(43) Veröffentlichungstag der Anmeldung:
**13.10.82 Patentblatt 82/41**

(45) Bekanntmachung des Hinweises auf die Patenterteilung:
**20.04.88 Patentblatt 88/16**

(84) Benannte Vertragsstaaten:
**CH FR GB IT LI SE**

(56) Entgegenhaltungen:
**EP - A - 0 028 798**
**EP - A - 0 029 163**
**DE - A - 2 947 669**

**E. Spenke: "pn-Übergänge", Springer-Verlag, Berlin 1979, S. 123-124**

(73) Patentinhaber: **Siemens Aktiengesellschaft Berlin und München, Wittelsbacherplatz 2, D-8000 München 2 (DE)**

(72) Erfinder: **Herberg, Helmut, Dr., Kobellstrasse 12, D-8000 München 2 (DE)**

## Beschreibung

Die Erfindung bezieht sich auf einen Thyristor mit innerer Stromverstärkung nach dem Oberbegriff des Patentanspruch 1.

Aus dem Buch «pn-Übergänge» von E. Spenke, Springer-Verlag, Berlin 1979, S. 123 und 124, vgl. insbesondere Abb. 16.15, ist ein Thyristor dieser Art bekannt. Der Hilfsemitter wird bei der Zündung des Thyristors von einem Strom durchflossen, der eine schnelle und grossflächige Zündung im Bereich des Hauptemitters bewirkt. Wegen des schnellen Ablaufs des gesamten Zündvorgangs ist ein Thyristor dieser Art für grosse Anstiegsgeschwindigkeiten des zwischen Anode und Kathode fliessenden Laststroms geeignet, d.h. er weist eine grosse di/dt-Festigkeit auf. Durch den Hilfsemitter, der stets zündempfindlicher ist als der Hauptemitter, ist andererseits die Stabilität des Thyristors geringer als die eines Thyristors gleichen Aufbaues, bei dem keine Massnahmen zur inneren Stromverstärkung vorgesehen sind. Unter Stabilität wird dabei die Sicherheit des Thyristors gegen unbeabsichtigte Zündvorgänge beim Auftreten von in Durchlassrichtung gepolten Spannungen verstanden, die unter Umständen sehr schnell ansteigen, also eine hohe dU/dt-Belastung darstellen.

Aus der DE-A-29 47 669 sind Thyristoren mit schaltbaren n-Emitterkurzschlüssen bekannt, die jeweils aus einem Randgebiet des n-Emitters, einer an dieses angrenzenden Teilzone der p-Basis und einem an diese angrenzenden, in die p-Basis eingefügten n-leitenden Gebiet bestehen, wobei die Teilzone durch ein gegenüber der Grenzfläche des Thyristors isoliertes, mit einem Steueranschluss versehenes Gate überdeckt ist und das n-leitende Gebiet mit der p-Basis leitend verbunden ist. Eine Hilfsemitterstruktur, die mit einem steuerbaren Halbleiterschalter versehen ist, lässt sich hieraus jedoch nicht entnehmen.

Die EP-A-00 28 798 und die EP-A-00 29 163 gehören gemäss Artikel 54(3) zum Stand der Technik. Das erstgenannte Dokument beschreibt einen Thyristor mit gategesteuerten, als MIS-Strukturen ausgebildeten Emitter-Kurzschlüssen. Dabei ist eine Hilfsemitterzone vorgesehen, die von einer Hilfsemitterelektrode kontaktiert wird. Die gategesteuerten Emitter-Kurzschlüsse sind an der Hilfsemitterzone vorgesehen, während der Hauptemitter mit herkömmlichen, festen Emitterkurzschlüssen versehen ist. Die gategesteuerten Emitter-Kurzschlüsse sind aber hier nicht so angeordnet, dass sie den direkten leitenden Kontakt zwischen der Hilfsemitterelektrode und der p-Basis, wie er bei dem eingangs genannten, bekannten Thyristor vorhanden ist, ersetzen. Das gleiche gilt auch für das letztgenannte Dokument.

Der Erfindung liegt die Aufgabe zugrunde, einen Thyristor mit innerer Stromverstärkung anzugeben, der die sich widersprechenden Forderungen nach einer guten Stabilität und einer grossen Zündempfindlichkeit weitgehend erfüllt. Das wird erfindungsgemäss durch eine Ausbildung des Thyristors gemäss dem kennzeichnenden Teil des Patentanspruchs 1 errreicht.

Der mit der Erfindung erzielbare Vorteil liegt insgesondere darin, dass der Hilfsemitter einerseits im nichtleitenden Zustand des Halbleiterschalters unwirksam ist und die Stabilität des Thyristors nicht verringert, während er andererseits im leitenden Zustand des Halbleiterschalters die Zündempfindlichkeit vergrössert. Wird die Drei-Schichten-Struktur, die den Hilfsemitter und die beiden Basisschichten umfasst, so ausgebildet, dass ihr Stromverstärkungsfaktor bezüglich der vom Hilfsemitter emittierten Ladungsträger grösser ist als der entsprechende Stromverstärkungsfaktor der Drei-Schichten-Struktur, die den Hauptemitter und die beiden Basisschichten umfasst, so steigt die erreichbare Zündempfindlichkeit mit dem Unterschied der genannten Stromverstärkungsfaktoren weiter an.

Die Patentansprüche 2 bis 12 sind auf bevorzugte Ausgestaltungen und Weiterbildungen der Erfindung gerichtet, während die Patentansprüche 13 und 14 vorteilhafte Verfahren zum Betrieb des erfindungsgemässen Thyristors angeben.

Die Erfindung wird nachfolgend anhand der Zeichnung näher beschrieben. Dabei zeigt:

Fig. 1 den Querschnitt eines ersten Ausführungsbeispiels der Erfindung,

Fig. 2 den Querschnitt eines zweiten Ausführungsbeispiels,

Fig. 3 den Querschnitt eines dritten Ausführungsbeispiels und

Fig. 4 den Querschnitt eines vierten Ausführungsbeispiels.

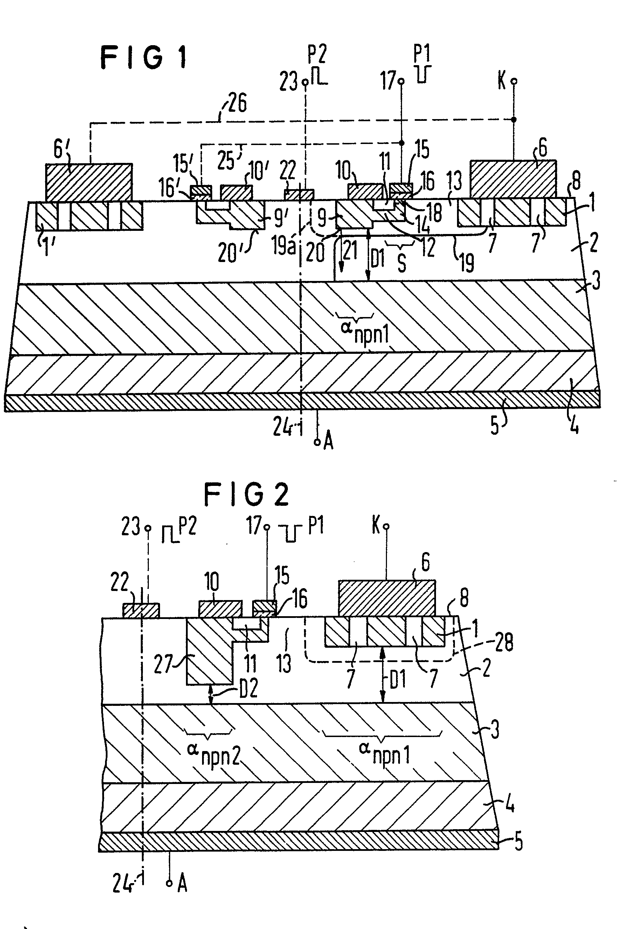

In Fig. 1 ist ein Thyristor dargestellt, der einen aus dotiertem Halbleitermaterial, z.B. Silizium, bestehenden Halbleiterkörper mit vier Schichten abwechselnder Leitungstypen aufweist. Dabei bezeichnet man die n-leitende Schicht 1 als den n-Emitter, die p-leitende Schicht 2 als die p-Basis, die n-leitende Schicht 3 als die n-Basis und die p-leitende Schicht 4 als den p-Emitter. Der p-Emitter 4 ist mit einer Anode 5 versehen, die einen Anschluss A hat, während der n-Emitter 1 eine Kathode 6 mit einem Anschluss K aufweist.

Der n-Emitter 1, der den Hauptemitter darstellt, wird von mehreren Ansätzen 7 der p-Basis 2 durchdrungen, die sich bis zur Grenzfläche 8 des Halbleiterkörpers erstrecken und in dieser mit der Kathode 6 leitend verbunden sind. Die Ansätze 7 stellen sog. feste Emitter-Kurzschlüsse dar, die eine unbeabsichtigte Zündung des Thyristors beim Anlegen einer Blockierspannung an die Anschlüsse A und K, die die Anode 5 auf ein positiveres Potential legt als die Kathode 6, weitgehend verhindern. Dies erklärt sich daraus, dass die unter dem Einfluss der Blockierspannung in Richtung auf den n-Emitter 1 transportierten Defektelektronen zum grössten Teil nicht zu dem pn-Übergang zwischen den Teilen 1 und 2 gelangen, sondern über die Ansätze 7 direkt zur Kathode 6, so dass sie keine Emission von Elektronen aus dem n-Emitter 1 auslösen. Mit wachsender Anzahl der festen Emitterkurzschlüsse 7 ist der Thyristor auch gegenüber grösseren oder schnell ansteigenden Blockierspannungen an den Anschlüssen A, K zündunempfindlich, d.h. stabil.

Ein n-leitendes Gebiet 9, das den Hilfsemitter darstellt, ist in die p-Basis 2 so eingefügt, dass es sich bis zur Grenzfläche 8 hin erstreckt. In dieser wird es von einer Hilfsemitterelektrode 10 kontaktiert.

Zum Unterschied von herkömmlichen Thyristoren mit innerer Stromverstärkung ist die Hilfsemitterelektrode 10 jedoch nicht unmittelbar mit der p-Basis 2 verbunden, sondern über einen Halbleiterschalter S. Dieser besteht bei dem Ausführungsbeispiel nach Fig. 1 aus einer FET-Struktur, welche auf bzw. in dem Halbleiterkörper 1 bis 4 vorgesehen ist. Zu dieser FET-Struktur gehört ein p-leitendes Halbleitergebiet 11, das in einen Ansatz 12 des Hilfsemitters so eingefügt ist, dass es sich bis zur Grenzfläche 8 erstreckt und in dieser von einem Teil der Hilfsemitterelektrode 10 kontaktiert wird. Ein zweites p-leitendes Halbleitergebiet wird von dem zwischen dem Hilfsemitter 9 und dem Hauptemitter 1 liegenden Teilbereich 13 der p-Basis 2 gebildet. Zwischen 11 und 13 liegt ein Randbereich 14 des Hilfsemitters 9, der von einem Gate 15 überdeckt ist, das durch eine dünne Isolierschicht 16, z.B. aus $SiO_2$, von der Grenzfläche 8 getrennt ist. Das Gate 15 ist mit einem Steuerspannungsanschluss 17 versehen. Handelt es sich bei dem Schalter S um eine FET-Struktur des Anreicherungstyps, so bildet sich beim Anlegen einer gegenüber K negativen, den Wert der Einsatzspannung übersteigenden Steuerspannung an den Anschluss 17 an der Grenzfläche 8 unterhalb von 15 ein Inversionskanal, der mit 18 angedeutet ist. Dieser p-leitende Kanal stellt eine niederohmige Verbindung zwischen den Gebieten 11 und 13 dar. Wird die Steuerspannung vom Anschluss 17 abgeschaltet, so wird der Kanal 18 beseitigt und die Verbindung zwischen den Gebieten 11 und 13 unterbrochen. Der Halbleiterschalter S verbindet also in einem ersten Schaltzustand die Hilfsemitterelektrode 10 niederohmig mit der p-Basis 2, so dass der Hilfsemitter 9 wirksam ist, während er in einem zweiten Schaltzustand die Elektrode 10 von der p-Basis 2 abtrennt, so dass der Hilfsemitter 9 unwirksam ist. Der Thyristor weist daher eine anschaltbare innere Stromverstärkung auf.

Nachfolgend wird die Zündung des Thyristors nach Fig. 1 erläutert. Dabei wird davon ausgegangen, dass eine den Thyristor in Durchlassrichtung polende Spannung an den Anschlüssen A und K liegt und dem Anschluss 17 eine negative Steuerspannung zugeführt wird. Unter dem Einfluss der erstgenannten Spannung bewegen sich beispielsweise thermisch erzeugte Defektelektronen längs des in Fig. 1 eingezeichneten Weges 19 in Richtung auf einen festen Emitterkurzschluss 7, so dass bei leitendem Kanal 18 am Punkt 20 ein Spannungsabfall entsteht, der den pn-Übergang zwischen dem wirksam geschalteten Hilfsemitter 9 und der p-Basis 2 so weit in Durchlassrichtung vorspannt, dass an dieser Stelle Elektronen in die p-Basis 2 emittiert werden. Die von 9 emittierten Elektronen bewegen sich in Richtung des Pfeils 21, wobei ein Teil von ihnen die Grenzfläche zwischen der n-Basis 3 und dem p-Emitter 4 erreicht und eine Emission von Defektelektronen aus dem p-Emitter veranlasst. Diese Emissionsvorgänge steigern sich gegenseitig, bis die Schichten 2 und 3 von emittierten Ladungsträgern überschwemmt sind, d.h. der Thyristor im Bereich des Hilfsemitters 9 gezündet hat. Der von A über den Hilfsemitter 9, die Hilfsemitterelektrode 10 und den Schalter S zum n-Emitter 1 und zur Kathode 6 fliessende Laststrom stellt dabei einen grossen Zündstrom für den n-Emitter 1 dar.

Sobald sich die gezündete Fläche des Thyristors von 9 ausgehend infolge einer lateralen Diffusion der Ladungsträger so weit ausgebreitet hat, dass sie den Bereich des n-Emitters 1 wenigstens teilweise mitumfasst, wird der zwischen A und K fliessende Laststrom vollständig von dem Teil des Thyristorquerschnitts übernommen, der den gezündeten Teil des n-Emitters 1 enthält. Der Hilfsemitter 9 wird dann nicht mehr vom Laststrom durchflossen. Dem Anschluss 17 kann also eine impulsförmige Steuerspannung P1 zugeführt werden, die dann abgeschaltet wird, wenn der Thyristorquerschnitt im Bereich des n-Emitters 1 stromführend geworden ist.

Für den Fall, dass eine Zündelektrode 22 auf der p-Basis 2 angeordnet ist, erfolgt die Zündung des Thyristors bei kleineren Spannungen zwischen A und K, als bei den vorstehenden Betrachtungen angenommen wurde, mittels eines Zündstromimpulses P2, der über einen bei 23 angeschlossenen Zündstromkreis zugeführt wird. Die Vorspannung am Schaltungspunkt 20 wird hierbei von Defektelektronen erzeugt, die aus dem Halbleiterbereich unterhalb der Zündelektrode 22 stammen und über die in Fig. 1 eingezeichneten Wege 19a und 19 zu einem festen Kurzschluss 7 gelangen. Dabei wird der Anschluss 17 gleichzeitig mit der Steuerspannung P1 beschaltet.

Der Thyristor wird gelöscht, wenn der Laststrom einen sogenannten Haltestrom unterschreitet. Das geschieht beispielsweise, wenn die Spannung von den Anschlüssen A und K abgeschaltet wird, oder, wenn es sich um eine Wechselspannung handelt, beim Auftreten des nächstfolgenden Nulldurchgangs.

Bei unwirksam geschaltetem Hilfsemitter 9 ist der beschriebene Thyristor infolge der festen Emitterkurzschlüsse 7 stabil, d.h. zündunempfindlich gegenüber hohen oder auch schnell ansteigenden Blockierspannungen an den Anschlüssen A und K. Andererseits wird er jedoch durch Wirksamschaltung des Hilfsemitters 9 mittels P1 im Zündzeitpunkt sehr zündempfindlich gemacht.

Bisher wurde aus Gründen der besseren Übersicht das Erfindungsprinzip anhand des in Fig. 1 rechts von der vertikalen Mittellinie 24 liegenden Teils des dargestellten Thyristors erläutert. Geht man nun in Fig. 1 von einem rotationssymmetrischen Aufbau des Thyristors mit der Linie 24 als Symetrieachse aus, so ergeben sich ringförmige Ausgestaltungen der Teile 1, 9, 10, 6, 15 und 16. Die Schnittflächen dieser Teile, die links von 24 liegen, sind mit 1', 9', 10', 6', 15' und 16' bezeichnet. Die Zündung einer solchen Struktur erfolgt längs eines zur Achse 24 konzentrischen Kreises, der die Punkte 20 und 20' enthält.

Andererseits kann die Linie 24 in Fig. 1 auch als eine senkrecht zur Bildebene stehende Symmetrieebene aufgefasst werden. Dabei weisen die Teile 1, 9, 10, 6, 15 und 16 zweckmässigerweise eine langgestreckte Form auf und verlaufen mit ihren grösseren Abmessungen senkrecht zur Zeichenebene, und zwar vorzugsweise über den ganzen Thyristorquerschnitt. Die Teile 1', 9', 10', 6', 15' und 16' stellen dann analoge Teilstrukturen auf der anderen Seite der Symmetrieebene dar, die bezüglich der letzteren symmetrisch zu den Teilen 1, 9, 10, 6, 15 und 16 liegen. Die Gates 15 und 15' sind in diesem Fall zum Zwecke einer gemeinsamen Ansteuerung miteinander verbunden, was durch eine eingezeichnete Leitung 25 angedeutet ist. Die Kathode 6' ist mit der Kathode 6 verbunden, was durch eine Leitung 26 angedeutet ist.

Die Teile 1, 9, 10, 6, 15 und 16 können mit Vorteil auch streifenartig ausgebildet und an der Grenzfläche 8 in Form einer Spirale oder in einer anderen Kurvenform angeordnet sein.

Der in Fig. 2 dargestellte Thyristor unterscheidet sich von Fig. 1 dadurch, dass der Hilfsemitter 9 durch einen Hilfsemitter 27 ersetzt ist, der sich tiefer in die p-Basis 2 hinein erstreckt als der n-Emitter 1. Wenn man für den n-Emitter 1 eine Eindringtiefe von z.B. 20 μm annimmt, so beträgt die des Hilfsemitters 27 beispielsweise etwa 50 μm, wobei diese Zahlenwerte nur zur Verdeutlichung des Schaltungsaufbaues genannt sind und keine einschränkende Bedeutung haben. Mit D1 ist der Abstand des n-Emitters 1 bzw. des Hilfsemitters 9 (Fig. 1) von der Grenzfläche zwischen den Schichten 2 und 3 bezeichnet, mit D2 der kleinere Abstand des Hilfsemitters 27 von dieser Grenzfläche. Für die aus den Teilen 27, 2 und 3 gebildete npn-Struktur ergibt sich ein Stromverstärkungsfaktor $\alpha_{npn2}$ für die beim Zünden des Thyristors von 27 emittierten Elektronen, der wegen des relativ kleinen Abstandes D2 grösser ist als der entsprechende Stromverstärkungsfaktor $\alpha_{npn1}$ der den grösseren Abstand D1 aufweisenden Struktur 1, 2 und 3. bzw. der Struktur 9, 2 und 3 (Fig. 1). Der Unterschied der Stromverstärkungsfaktoren erklärt sich daraus, dass die Rekombinationsrate der von 27 emittierten Elektronen wegen des kleineren Abstandes D2 kleiner ist als die Rekombinationsrate der von 1 bzw. von 9 emittierten Elektronen. Die Zündempfindlichkeit des Thyristors nach Fig. 2 ist in dem Masse grösser als die des Thyristors nach Fig. 1, als $\alpha_{npn2}$ grösser ist als $\alpha_{npn1}$.

In Fig. 2 ist auch eine von der Eindringtiefe des Hilfsemitters 27 unabhängige Massnahme angedeutet, durch die die Stabilität des Thyristors erhöht werden kann. Sie besteht darin, dass der n-Emitter 1 von einem Teilbereich 28 der p-Basis 2 umgeben ist, der eine zusätzliche p-Dotierung aufweist, so dass sein Dotierungsgrad höher ist als der der übrigen Teilbereiche der p-Basis 2. Das hat zur Folge, dass die aus den Teilen 1, 2 und

3 bestehende Drei-Schichten-Struktur der Fig. 2 einen Stromverstärkungsfaktor bezüglich der von 1 emittierten Elektronen aufweist, und zwar unter der Voraussetzung einer bei A und K in Durchlassrichtung des Thyristors angelegten Spannung und bei unwirksam geschaltetem Hilfsemitter 27, der kleiner ist als der Stromverstärkungsfaktor dieser Struktur ohne zusätzlich dotierten Teilbereich 28. Bei einer Störstellenkonzentration der p-Basis 2 von etwa $5 \times 10^{16} \mathrm{cm}^{-3}$ kommt für den Teilbereich 28 beispielsweise eine Störstellenkonzentration von etwa $2 \times 10^{17} \mathrm{cm}^{-3}$ in Betracht, wobei diese Zahlenangaben nur zur Erläuterung des genannten Dotierungsunterschiedes dienen und nicht als Grenzwerte aufzufassen sind.

Eine Erhöhung der Stabilität des Thyristors nach Fig. 2 lässt sich auch in der Weise erreichen, dass der Teilbereich 28 nicht stärker dotiert wird als die übrigen Teile des p-Emitters 2, sondern stattdessen mit zusätzlichen Rekombinationszentren versehen wird. Dies geschieht z.B. durch eine auf den Teilbereich 28 beschränkte Bestrahlung der p-Basis 2 vor dem Erzeugen des n-Emitters 1 mit einem Elektronenstrahl. Andererseits können auch Rekombinationszentren in Form von Gold- oder Platinatomen durch Diffusion oder Implantation in den Teilbereich 28 eingebracht werden.

Der in Fig. 2 dargestellte Thyristor wird in derselben Weise betrieben wie der Thyristor nach Fig. 1.

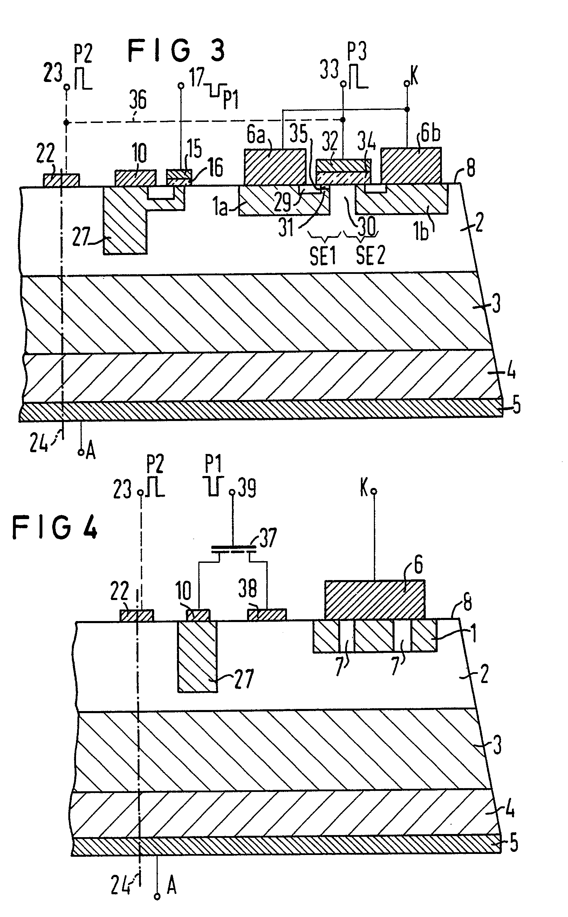

Das in Fig. 3 dargestellte Ausführungsbeispiel unterscheidet sich von Fig. 2 in erster Linie dadurch, dass anstelle der festen Emitterkurzschlüsse 7 steuerbare Emitterkurzschlüsse vorgesehen sind. Der n-Emitter 1 von Fig. 1 ist zu diesem Zweck in zwei oder mehrere Emitterteilgebiete 1a, 1b unterteilt, von denen jedes mit einem Teil 6a bzw. 6b der Kathode versehen ist. Die Teile 6a und 6b sind miteinander verbunden und an einen gemeinsamen Anschluss K geführt.

Ein in Fig. 3 mit SE 1 bezeichneter steuerbarer Emitterkurzschluss weist ein in das Emitterteilgebiet 1a eingefügtes, p-leitendes Halbleitergebiet 29 auf, das sich bis zur Grenzfläche 8 des Halbleiterkörpers erstreckt und in dieser von dem Teil 6a der Kathode kontaktiert wird. Die Emitterteilgebiete 1a und 1b sind durch einen Bereich 30 der p-Basis 2 voneinander getrennt, der als ein zweites p-leitendes Halbleitergebiet des steuerbaren Emitterkurzschlusses aufzufassen ist. Zwischen den Gebieten 29 und 30 liegt ein von der Grenzfläche 8 ausgehender Randbereich 31 des Emitterteilgebiets 1a, der n-leitend ist. Letzterer wird von einem Gate 32 überdeckt, das einen Anschluss 33 aufweist und von einer dünnen, elektrisch isolierenden Schicht 34, z.B. aus $SiO_2$, von dem Halbleiterkörper getrennt ist. Die Teile 29 bis 34 bilden eine FET-Struktur des Verarmungstyps, bei der ohne Zuführung einer Steuerspannung an den Anschluss 33 ein p-leitender Kanal 35 in dem Randbereich 31 besteht, der das Gebiet 29 mit dem Bereich 30 und damit den Teil 6a der Kathode mit der p-Basis 2 niederohmig verbindet. Der Kanal 35 ist entweder ein Inversionskanal oder ein durch eine p-Dotierung an der Grenzfläche 8 erzeugter, dotierter Kanal. Der Emitterkurzschluss SE1 ist also bei spannungsfreiem Anschluss 33 wirksam geschaltet. Führt man dem Anschluss 33 eine positive Steuerspannung zu, so wird der Kanal 35 beseitigt und die niederohmige Verbindung der Teile 2 und 6a unterbrochen, d.h. der Emitterkurzschluss SE1 unwirksam geschaltet.

In Fig. 3 ist randseitig zu dem Emitterteilgebiet 1b ein weiterer steuerbarer Emitterkurzschluss SE2 vorgesehen, der entsprechend SE1 aufgebaut ist. Dabei ist das Gate 32 den Emitterkurzschlüssen SE1 und SE2 gemeinsam zugeordnet. Die übrigen Schaltungsteile von Fig. 3 entsprechen den mit den gleichen Bezugszeichen versehenen Teilen von Fig. 1 und Fig. 2.

Anstelle der beiden dargestellten Emitterteilgebiete 1a und 1b können bei dem Ausführungsbeispiel nach Fig. 3 auch mehrere entsprechend ausgebildete Emitterteilgebiete oder auch nur ein einziges solches Teilgebiet, z.B. 1a oder 1b, vorgesehen sein.

Mit dem Ausführungsbeispiel nach Fig. 3 wird eine besonders hohe Stabilität erreicht, und zwar insb. dann, wenn eine grössere Anzahl von Emitterteilgebieten 1a, 1b ... und eine entsprechend grosse Anzahl von steuerbaren Emitterkurzschlüssen SE1, SE2... vorgesehen sind. Diese werden durch eine zum Zündzeitpunkt am Anschluss 33 liegende positive Steuerspannung, z.B. impulsförmige Steuerspannung P3 unwirksam geschaltet, so dass die Ausbreitung der gezündeten Front über den gesamten Thyristorquerschnitt durch die Emitterkurzschlüsse nicht behindert wird. Ist der Thyristorquerschnitt im Bereich der Emitterteilgebiete 1a, 1b stromführend geworden, kann die Steuerspannung abgeschaltet werden, wie durch P3 angedeutet ist. Ist ein Anschluss 23 vorgesehen, dem ein Zündstromimpuls P2 zugeführt wird, so kann der Anschluss 33 mit 23 durch eine Leitung 36 verbunden werden, um die an 23 abfallende Spannung als Steuerspannung P3 zu verwenden. Die Steuerung des Anschlusses 17 erfolgt in der bereits anhand von Fig. 1 erläuterten Weise.

Die bisher beschriebenen FET-Strukturen, z.B. 29 bis 34, des Verarmungstyps können auch durch FET-Strukturen des Anreicherungstyps ersetzt sein, wenn ihren Gateanschlüssen, z.B. 33, eine zusätzliche negative Steuerspannung zugeführt wird, die Inversionskanäle, z.B. 35, entstehen lässt. Dieser zusätzlichen Steuerspannung wird dann die Steuerspannung P3 im Zündzeitpunkt überlagert, um die Kanäle aufzuheben.

Fig. 4 zeigt ein Ausführungsbeispiel, bei dem der Hilfsemitter 27 über einen Halbleiterschalter in Form eines externen Feldeffekttransistors 37 mit der p-Basis 2 leitend verbunden ist. Dabei ist die Source-Drain-Strecke von 37 einerseits mit der Hilfsemitterelektrode 10 und andererseits mit einer leitenden Belegung 38 verbunden, die die p-Basis 2 kontaktiert. Die Hilfsemitterelektrode 10 ragt dabei nicht über die lateralen Abmessungen des Hilfsemitters 27 hinaus. Das Gate von 37 ist mit einem Steuerspannungsanschluss 39 versehen. Der Betrieb des Thyristors nach Fig. 4 erfolgt in der anhand von Fig. 1 beschriebenen Weise, wobei der Anschluss 39 dem Anschluss 17 entspricht und bei einem p-Kanal-FET 37 mit der Steuerspannung P1 belegt ist, während dem Anschluss 23 gegebenenfalls ein Zündstromimpuls P2 zugeführt wird.

Bei einem n-Kanal-FET 37 wird dem Anschluss 39 zur Wirksamschaltung des Hilfsemitters 27 ein positiver Steuerspannungsimpuls zugeführt. Letzterer kann bei einer Verbindung der Anschlüsse 23 und 39 aus der Spannung bestehen, die am Anschluss 23 infolge des Steuerstromimpulses P2 abfällt.

Im Rahmen der Erfindung kann der Hilfsemitter auch p-leitend sein, lateral neben dem p-Emitter in der n-Basis des Thyristors angeordnet sein und zur Herstellung einer grossen Zündempfindlichkeit über einen Halbleiterschalter mit der n-Basis niederohmig verbunden werden. In diesem Fall sind dann auch die festen oder steuerbaren Emitterkurzschlüsse im Bereich des p-Emitters vorgesehen. Sämtliche Figuren können zur Darstellung dieser Schaltungsvariante herangezogen werden, wenn die Bezeichnungen der Anschlüsse A und K miteinander vertauscht werden, die Halbleiterteile jeweils die entgegengesetzten Leitungstypen zu den bisher beschriebenen erhalten und die genannten Steuerspannungen sowie der Steuerstrom mit entgegengesetzter Polarität zugeführt werden.

Die Ausführungsbeispiele nach den Figuren 2 bis 4 können entsprechend Fig. 1 jeweils zu einer Symmetrieachse 24 zentrisch symmetrisch abgebildet sein oder jeweils zu einer Ebene, die auf die Bildebene senkrecht steht und durch 24 angedeutet ist, symmetrisch aufgebaut sein.

Die Teile 1, 1a, 1b, 6, 6b, 10, 15, 16, 27 und 32 und 34 der Figuren 2 bis 4 können mit Vorteil auch streifenartig ausgebildet und an der Grenzfläche 8 in Form einer Spirale oder in einer anderen Kurvenform angeordnet sein.

Die Ausführungsbeispiele nach den Figuren 2 oder 3 können auch mit einem Halbleiterschalter in Form eines externen Transistors ausgestattet sein. Weiterhin können die festen Emitterkurzschlüsse 7 in allen Figuren durch steuerbare Emitterkurzschlüsse, z.B. SE1 oder SE2, ersetzt sein.

**Patentansprüche**

1. Thyristor mit einem Halbleiterkörper, der einen von einer Kathode (6) kontaktierten n-Emitter (1), einen von einer Anode (5) kontaktierten p-Emitter (4) und zwei an diese jeweils angrenzende, durch eine Grenzfläche voneinander getrennte Basisschichten (2, 3) unterschiedlichen Leitfähigkeitstyps enthält und der einen zur inneren Stromverstärkung dienenden, dem n(p)-Emitter (1) zugeordneten Hilfsemitter (9) aufweist, welcher von einer Hilfsemitterelektrode (10) kontaktiert ist, dadurch gekennzeichnet, dass die Hilfsemitterelektrode (10) keine unmittelbare Verbindung zur angrenzenden Basisschicht (2) aufweist, sondern über einen Halbleiterschalter (S) mit der an den Hilfsemitter (9) angrenzenden Basischicht (2) verbunden ist.

2. Thyristor nach Anspruch 1, dadurch gekennzeichnet, dass in den Hilfsemitter (9) ein zu diesem entgegengesetzt dotiertes Halbleitergebiet (11) eingefügt ist, das sich bis zu einer Grenzfläche (8) des Halbleiterkörpers erstreckt und in dieser von einem Teil der Hilfsemitterelektrode (10) kontaktiert wird, und dass das entgegengesetzt dotierte Halbleitergebiet (11) zusammen mit einem sich bis zur Grenzfläche erstreckenden Teilbereich (13) der an den Hilfsemitter (9) angrenzenden Basisschicht (2) und einem zwischen dem Halbleitergebiet (11) und dem Teilbereich (13) liegenden, sich bis zur Grenzfläche erstreckenden Randbereich (14) des Hilfsemitters (9) den Halbleiterschalter (S) bilden, wobei der Randbereich (14) des Hilfsemitters durch ein mit einem ersten Steuerspannungsanschluss (17) versehenes Gate (15) überdeckt ist, das durch eine dünne, elektrisch isolierende Schicht (16) von dem Halbleiterkörper getrennt ist.

3. Thyristor nach Anspruch 1, dadurch gekennzeichnet, dass der Halbleiterschalter aus einem externen Feldeffekttransistor (37) besteht, dessen Source- bzw. Drainanschluss mit der die lateralen Begrenzungen des Hilfsemitters (27) nicht überragenden Hilfsemitterelektrode (10) bzw. der an den Hilfsemitter angrenzenden Basisschicht (2) verbunden sind und dessen Gate mit einem zweiten Steuerspannungsanschluss (39) versehen ist.

4. Thyristor nach einem der Ansprüche 1 bis 3, dadurch gekennzeichnet, dass der Hilfsemitter (27) mit den beiden Basisschichten (2, 3) eine npn- oder pnp-Struktur bildet, deren im leitenden Zustand des Halbleiterschalters und beim Anlegen einer Blockierspannung bestehender Stromverstärkungsfaktor $\alpha_{npn2}$, bezogen auf die von dem Hilfsemitter (27) emittierten Ladungsträger, grösser ist als der entsprechende Stromverstärkungsfaktor der npn- oder pnp-Struktur, die aus dem n(p)-Emitter (1) und den beiden Basisschichten (2, 3) gebildet ist.

5. Thyristor nach Anspruch 1, dadurch gekennzeichnet, dass der Abstand des Hilfsemitters (27) von dem zwischen den beiden Basisschichten (2, 3) bestehenden pn-Übergang kleiner ist als der Abstand des n(p)-Emitters (1) von diesem pn-Übergang.

6. Thyristor nach Anspruch 4, dadurch gekennzeichnet, dass der n(p)-Emitter (1) von einem Teilbereich (28) der angrenzenden Basisschicht (2) umgeben ist, dessen Dotierungsgrad höher ist als der Dotierungsgrad des Teilbereiches dieser Basisschicht, der den Hilfsemitter (27) umgibt.

7. Thyristor nach Anspruch 4, dadurch gekennzeichnet, dass der n(p)-Emitter (1) von einem Teilbereich (28) der angrenzenden Basisschicht (2) umgeben ist, der eine grössere Anzahl von Rekombinationszentren pro Raumeinheit aufweist als der Teilbereich dieser Basisschicht, der den Hilfsemitter (27) umgibt.

8. Thyristor nach einem der vorhergehenden Ansprüche, dadurch gekennzeichnet, dass der n(p)-Emitter (1) mit wenigstens einem festen Emitterkurzschluss (7) versehen ist, der aus einem Ansatz der an den n(p)-Emitter (1) angrenzenden Basisschicht (2) besteht, welcher den n(p)-Emitter (1) bis zu der Grenzfläche (8) des Halbleiterkörpers durchdringt und in dieser von der Kathode (Anode) (6) kontaktiert wird.

9. Thyristor nach einem der vorhergehenden Ansprüche, dadurch gekennzeichnet, dass der n(p)-Emitter (1a, 1b) mit wenigstens einem steuerbaren Emitterkurzschluss (SE1) versehen ist, der ein mit der Kathode (Anode) (6a) verbundenes, erstes Halbleitergebiet (29) eines ersten Leitungstyps, ein mit der an den Hilfsemitter (27) angrenzenden Basisschicht (2) verbundenes zweites Halbleitergebiet (30) des ersten Leitungstyps und ein zwischen diesen Halbleitergebieten liegendes Halbleitergebiet (31) aufweist und dass das letztere Halbleitergebiet (31) von einem gegenüber dem Halbleiterkörper elektrisch isolierten Gate (32) überdeckt ist, das mit einem dritten Steuerspannungsanschluss (33) versehen ist.

10. Thyristor nach einem der vorhergehenden Ansprüche, dadurch gekennzeichnet, dass die an den Hilfsemitter (9) angrenzende Basischicht (2) mit einer Zündelektrode (22) versehen ist, die einen Anschluss (23) für einen Zündstromkreis aufweist.

11. Thyristor nach einem der Ansprüche 3 oder 9 und Anspruch 10, dadurch gekennzeichnet, dass der Anschluss (23) für den Zündstromkreis mit dem zweiten und/oder dritten Steuerspannungsanschluss (39, 33) verbunden ist.

12. Thyristor nach einem der vorhergehenden Ansprüche, dadurch gekennzeichnet, dass sich die Anode (5) und die Kathode (6, 6a, 6b) auf einander gegenüberliegenden Grenzflächen des Halbleiterkörpers befinden.

13. Verfahren zum Betrieb eines Thyristors nach einem der vorhergehenden Ansprüche, dadurch gekennzeichnet, dass zum Zünden desselben der Halbleiterschalter (S, 37) leitend geschaltet wird.

14. Verfahren nach Anspruch 13, dadurch gekennzeichnet, dass zum Zünden des Thyristors dem Steuerspannungsanschluss (17) des Halbleiterschalters bei einer Ausbildung desselben als ein p(n)-Kanal-Feldeffekttransistor des Anreicherungstyps ein negativer (positiver) Steuerspannungsimpuls und ggf. dem Steuerspannungsanschluss (33) des steuerbaren Emitterkurzschlusses (SE1) bei einer Ausbildung desselben als p(n)-Kanal-Feldeffekttransistor des Verarmungstyps ein positiver (negativer) Spannungsimpuls zugeführt wird.

**Claims**

1. A thyristor comprising a semiconductor component which contains an n-emitter (1) contacted by a cathode (6), a p-doped emitter (4) contacted by an anode (5), carrying two adjoining base layers (2, 3) of different conductivity types separated from one another by a boundary surface, and including an auxiliary emitter (9) which serves for internal current amplification and assigned to the n(p)-emitter (1) and contacted via an auxiliary emitter electrode (10), characterised in that the auxiliary emitter electrode (10) is not directly connected to the adjacent base layer (2) but is connected via a semiconductor switch (S) to the base layer (2) adjacent the auxiliary emitter (9).

2. A thyristor as claimed in Claim 1, characterised in that an oppositely doped semiconductor zone (11) is formed in the auxiliary emitter (9) and extends to a boundary surface (8) of the semiconductor component in which it is contacted by a part of the auxiliary emitter electrode (10), and that the oppositely doped semiconductor zone (11), together with a subsidiary zone (13) extending to the boundary surface of the base layer (2) adjacent the auxiliary emitter (9), and together with an edge zone (14) of the auxiliary emitter (9) located between the semiconductor zone (11) and the subsidiary zone (13) and extending to the boundary surface, form the semiconductor switch (S), where the edge zone (14) of the auxiliary emitter is covered by a gate (15) provided with a first control voltage terminal (17) and separated from the semiconductor component by a thin, electrically insulating layer (16).

3. A thyristor as claimed in Claim 1, characterised in that the semiconductor switch consists of an external field-effect transistor (37) whose source and drain terminals are respectively connected to the auxiliary emitter electrode (10) which does not project beyond the lateral dimensions of the auxiliary emitter (27), and to the base layer (2) which adjoins the auxiliary emitter, and whose gate is provided with a second control voltage terminal (39).

4. A thyristor as claimed in one of Claims 1 to 3, characterised in that the auxiliary emitter (27), together with the two base layers (2, 3), forms an npn or pnp-structure whose current amplification factor $\alpha_{npn2}$, which occurs when the semiconductor switch is in the conductive state and when a blocking voltage is connected, relative to the charge carriers emitted by the auxiliary emitter (27), is greater than the corresponding current amplification factor of the npn or pnp-structure composed of the n(p)-emitter (1) and the two base layers (2, 3).

5. A thyristor as claimed in Claim 4, characterised in that the distance of the auxiliary emitter (27) from the pn-junction which exists between the two base layers (2, 3) is shorter than the distance of the n(p)-emitter (1) from this pn-junction.

6. A thyristor as claimed in Claim 4, characterised in that the n(p)-emitter (1) is surrounded by a subsidiary zone (28) of the adjacent base layer (2) whose level of doping is higher than the level of doping of that subsidiary zone of this base layer which surrounds the auxiliary emitter (27).

7. A thyristor as chlaimed in Claim 4, characterised in that the n(p)-emitter (1) is surrounded by a subsidiary zone (28) of the adjacent base layer (2) which has a larger number of recombination centres per unit of space than that subsidiary zone of the base layer which surrounds the auxiliary emitter (27).

8. A thyristor as claimed in one of the preceding Claims, characterised in that the n(p)-emitter (1) is provided with at least one fixed emitter short-circuit (7) which consists of a projection of the base layer (2) which adjoins the n(p)-emitter (1), and penetrates through the n(p)-emitter (1) to the boundary surface (8) of the semiconductor component where it is contacted by the cathode (anode) (6).

9. A thyristor as claimed in one of the preceding Claims, characterised in that the n(p)-emitter (1a, 1b) is provided with at least one controllable emitter short-circuit (SE1) which comprises a first semiconductor zone (29) of a first conductivity type, connected to the cathode (anode) (6a), a second semiconductor zone (30) of the first conductivity type connected to the base layer (2) which adjoins the auxiliary emitter (27), and a semiconductor Zone (31) located between these semiconductor zones, and that the latter semiconductor zone (31) is covered by a gate (32) electrically insulated from the semiconductor component and provided with a third control voltage terminal (33).

10. A thyristor as claimed in one of the preceding Claims, characterised in that the base layer (2) which adjoins the auxiliary emitter (9) is provided with an ignition electrode (22) which has a terminal (23) for an ignition circuit.

11. A thyristor as claimed in one of Claims 3 or 9 and 10, characterised in that the terminal (23) for the ignition circuit is connected to the second and/or third control voltage terminal (39, 33).

12. A thyristor as claimed in one of the preceding Claims, characterised in that the anode (5) and the cathode (6, 6a, 6b) are arranged on oppositely located boundary surfaces of the semiconductor component.

13. A method of operating a thyristor as claimed in one of the preceding Claims, characterised in that for the ignition of said thyristor the semiconductor switch (S, 37) is switched conductive.

14. A process as claimed in Claim 13, characterised in that for the ignition of the thyristor, the control voltage terminal (17) of the semiconductor switch is supplied with a negative (positive) control voltage pulse when said semiconductor switch is in the form of a p(n)-channel field-effect transistor of the enhancement type, and where appropriate the control voltage terminal (33) of the controllable emitter short-circuit (SE1) is supplied with a positive (negative) voltage pulse when said emitter short-circuit is in the form of a p(n)-channel field-effect transistor of the depletion type.

**Revendications**

1. Thyristor comportant un corps semiconducteur, qui possède un émitter (1) de type n en contact avec une cathode (6), un émetteur (4) de type p en contact avec une anode (5) et deux couches de base (2, 3) jouxtant respectivement ces émetteurs et séparées l'une de l'autre par une interface et possédant des types de conductivité différents, et un émetteur auxiliaire (9) servant à réaliser l'amplification intérieure du courant et associé à l'émetteur (1) de type n (p) et qui est en contact avec une électrode de l'émetteur auxiliaire (9), caractérisé par le fait que l'électrode d'émetteur auxiliaire (10) ne comporte aucune liaison directe avec la couche de base contiguë (2), mais est reliée par l'intermédiaire d'un interrupteur à semiconducteurs (S) à la couche de base (2) jouxtant l'émetteur auxiliaire (9).

2. Thyristor suivant la revendication 1, caractérisé par le fait que dans l'émetteur auxiliaire (9) est insérée une région semiconductrice (11) qui est dopée avec un dopage opposé à celui de cet émetteur, s'étend jusqu'à une surface limite (8) du corps semiconducteur et est en contact, au niveau de cette interface, avec une partie de l'électrode d'émetteur auxiliaire (10), et que la région semiconductrice (11) dopée avec un dopage opposé forme l'interrupteur à semiconducteurs (S), en association avec une région partielle (13), qui s'étend jusqu'à la surface limite, de la couche de base (2) jouxtant l'émetteur auxiliaire (9) et une zone marginale (14) de l'émetteur auxiliaire (9), qui est située entre la région semiconductrice (11) et la région partielle (13) et s'étend jusqu'à la surface limite, la zone marginale (14) de l'émetteur auxiliaire étant recouverte par une grille (15) comportant une première borne (17) d'application d'une tension de commande et qui est séparée du corps semiconducteur par une couche mince électriquement isolante (16).

3. Thyristor suivant la revendication 1, caractérisé par le fait que l'interrupteur à semiconducteurs est constituée par un transistor extérieur à effet de champ (37), dont la borne de source ou de drain est reliée à l'électrode d'émetteur auxiliaire (10), qui ne fait pas saillie au-delà des limites latérales de l'émetteur auxiliaire (27), ou à la couche de base (2) jouxtant l'émetteur auxiliaire, et dont la grille est munie d'une seconde borne (39) d'application d'une tension de commande.

4. Thyristor suivant l'une des revendications 1 à 3, caractérisé par le fait que l'émetteur auxiliaire (27) forme, avec les deux couches de base (2, 3), une structure npn ou pnp, dont le facteur d'amplification de courant $\alpha_{npn2}$, qui est présent lorsque l'interrupteur à semiconducteurs est conducteur et lors de l'application d'une tension de blocage et qui est rapporté aux porteurs de charge émis par l'émetteur auxiliaire (27), est supérieur au facteur d'amplification de courant correspondant de la structure npn ou pnp, qui est formée par l'émetteur (1) de type n(p) et par les deux couches de base (2, 3).

5. Thyristor suivant la revendication 4, caractérisé par le fait que la distance entre l'émetteur auxiliaire (27) et la jonction pn formée entre les deux couches de base (2, 3) est inférieure à la distance entre l'émetteur (1) de type n(p) et cette jonction pn.

6. Thyristor suivant la revendication 4, caractérisé par le fait que l'émetteur (1) de type n(p) est entouré par une région partielle (28) de la couche de base contiguë (2), dont le degré de dopage est supérieur au degré de dopage de la région partielle de cette couche de base, qui entoure l'émetteur auxiliaire (27).

7. Thyristor suivant la revendication 4, caractérisé par le fait que l'émetteur (1) de type n(p) est entouré par une région partielle (28) de la couche de base contiguë (2), qui contient un nombre de centres de recombinaison par unité de volume, qui est plus élevé que dans la région partielle de cette couche de base, qui entoure l'émetteur auxiliaire (27).

8. Thyristor suivant l'une des revendications précédentes, caractérisé par le fait que l'émetteur (1) de type n(p) comporte au moins un court-circuit d'émetteur fixe (7), qui est constitué par une partie saillante de la couche de base (2) jouxtant l'émetteur (1) de type n(p) et qui traverse l'émetteur (1) de type n(p) jusqu'à la surface limite (8) du corps semiconducteur et est en contact, au niveau de cette surface limite, avec la cathode (l'anode) (6).

9. Thyristor suivant l'une des revendications précédentes, caractérisé par le fait que l'émetteur (1a, 1b) de type n(p) comporte au moins un court-circuit d'émetteur commandable (SE1), qui comporte une première région semiconductrice (29) possédant un premier type de conductivité et relié à la cathode (l'anode) (6a), une seconde région semiconductrice (3) possédant un premier type de conductivité et reliée à la couche de base (2) jouxtant l'émetteur auxiliaire (27), et une seconde région semiconductrice (31) située entre ces régions semiconductrices, et que la dernière région semiconductrice (31) est recouverte par une grille (32) isolée du point de vue électrique par rapport au corps semiconducteur et qui est munie d'une troisième borne (33) d'application d'une tension de commande.

10. Thyristor suivant l'une des revendications précédentes, caractérisé par le fait que la couche de base (2), qui jouxte l'émetteur auxiliaire (9), est munie d'une électrode d'amorçage (22) qui comporte une borne (23) pour un circuit d'amorçage.

11. Thyristor suivant l'une des revendications 3 ou 9 et la revendication 10, caractérisé par le fait que la borne (23) pour le circuit d'amorçage est reliée à la seconde et/ou à la troisième borne (39, 33) d'application d'une tension de commande.

12. Thyristor suivant l'une des revendications précédentes, caractérisé par le fait que l'anode (5) et la cathode (6, 6a, 6b) sont situées sur des surfaces limites, opposées l'une à l'autre, du corps semiconducteur.

13. Procédé d'utilisation d'un thyristor suivant l'une des revendications précédentes, caractérisé par le fait que pour l'amorçage du thyristor, on rend conducteur l'interrupteur à semiconducteurs (S, 37).

14. Procédé suivant la revendication 13, caractérisé par le fait que pour réaliser l'amorçage du thyristor, on applique une impulsion négative (positive) à la tension de commande à la borne (17) d'application d'une tension de commande de l'interrupteur à semiconducteurs lorsque ce dernier est réalisé sous la forme d'un transistor à effet de champ à canal p(n), du type à enrichissement, et qu'on envoie éventuellement une impulsion de tension positive (négative) à la borne (33) d'application d'une tension de commande du court-circuit d'émetteur commandable (SE1), dans le cas où ce dernier est réalisé sous la forme d'un transistor à effet de champ à canal p(n).

FIG 1

FIG 2

# F I G 3

# F I G 4